## Europäisches Patentamt
## European Patent Office
## Office européen des brevets

(19)

(11) Veröffentlichungsnummer: **0 144 915**
**B1**

(12) **EUROPÄISCHE PATENTSCHRIFT**

(45) Veröffentlichungstag der Patentschrift:
02.08.89

(51) Int. Cl.⁴: **H 01 L 21/607**

(21) Anmeldenummer: **84114466.0**

(22) Anmeldetag: **29.11.84**

(54) **Verfahren zum Anheften eines dünnen elektrisch leitenden Drahtes an elektronischen Bauteilen, insbesondere Halbleiterbauelementen.**

(30) Priorität: **02.12.83 DE 3343738**

(43) Veröffentlichungstag der Anmeldung:
**19.06.85 Patentblatt 85/25**

(45) Bekanntmachung des Hinweises auf die Patenterteilung:
**02.08.89 Patentblatt 89/31**

(84) Benannte Vertragsstaaten:
**AT BE CH DE FR GB IT LI NL SE**

(56) Entgegenhaltungen:
**DE-A-2 247 581**
**US-A-4 142 714**
**US-A-4 422 568**

**PATENTS ABSTRACTS OF JAPAN, Band 7, Nr. 72 (E-166) 1217 , 25. Marz 1983; & JP-A-58 143 (SHINKAWA K.K.) 05-01-1983**

(73) Patentinhaber: **Deubzer- Eltec GmbH, Kolpingring 18, D-8024 Oberhaching (DE)**

(72) Erfinder: **Urban, Peter, Gärtnerstrasse 4, Kolbermoor (DE)**

(74) Vertreter: **Popp, Eugen, Dr., MEISSNER, BOLTE & PARTNER Widenmayerstrasse 48 Postfach 86 06 24, D-8000 München 86 (DE)**

LIBER, STOCKHOLM 1989

## Beschreibung

Die Erfindung betrifft ein Verfahren und eine Vorrichtung zum Anheften eines elektrisch leitenden Drahts an elektrische Kontaktstellen (Bonden) nach Oberbegriff von Anspruch 1 bzw. 3.

Bei der Herstellung von Mikroschaltkreisen bzw. integrierten Schaltkreisen müssen elektrische Verbindungen zwischen einzelnen Schaltkreisen auf einem Chip bzw. Substrat und externen Anschlüssen hergestellt werden. Hierbei werden üblicherweise dünne Gold- oder Aluminiumdrähte mit einem Durchmesser von ca. 25 - 500 µ an den einzelnen Kontaktstellen bzw. -Flächen selbst bestehend aus dünnen Gold- oder Aluminiumschichten, die auf dem Substrat aufgebracht sind und in elektrischer Verbindung mit den entsprechenden Schaltkreisen bzw. den externen Anschlüssen stehen.

Das Anschweißen der Drähte nennt man auch "Bonden" und erfolgt unter Einwirkung von Druck sowie zusätzlich durch Energiezufuhr in Form von Ultraschall und/oder direkter Wärmeenergie.

Die vorliegende Erfindung befaßt sich in erster Linie mit einem Kontaktierverfahren sowie einer entsprechenden Vorrichtung, mit dem bzw. der ein dünner Aluminiumdraht unter Einwirkung von Druck und Ultraschall mit einer Kontaktstelle von elektrischen oder elektronischen Bauteilen, insbesondere Halbleiterbauelementen etc., verschweißt wird. Bei Verwendung von etwas stärkeren Aluminiumdrähten ist es notwendig, den angehefteten bzw. gebondeten Drahtabschnitt mittels eines dem Bondkopf zugeordneten Schneidwerkzeuges vom übrigen Aluminiumdraht abzutrennen. Das Schneidwerkzeug umfaßt ein Trennmesser, das in geringem Abstand von der der Drahtzuführungsseite des Bondkopfs bzw. des auf den Draht einwirkenden Ultraschallerregten Preßstempels gegenüberliegenden Seite wirksam ist. Dieser geringe Abstand zwischen Schneidwerkzeug und Bondkopf bzw. Preßstempel (auch "wedge" genannt) ist zur unbeeinflußten Schwingung des "wedge" erforderlich; d.h. durch diese geringe Beabstandung bzw. Entkoppelung des Schneidwerkzeugs vom Ultraschall-erregten "wedge" wird eine Störung der Ultraschallschwingung desselben durch das Trennwerkzeug vermieden.

Die erwähnte Beabstandung zwischen Schneidwerkzeug und "wedge" hat jedoch den Nachteil, daß der Aluminiumdraht nach Abtrennung noch geringfügig über die der Drahtzuführungseite des "wedge" gegenüberliegenden Seite vorsteht. Bei genügend großen Kontaktstellen bzw. -Flächen bleibt dieser überstehende Drahtabschnitt, auch "tail" genannt, ohne Einfluß. Bei kleineren Kontaktflächen kann durch den erwähnten "tail" eine Kontraktierung der benachbarten Kontaktstelle und damit ein Kurzschluß im Halbleiterbauelement oder dergleichen nicht vermieden werden.

Der vorliegenden Erfindung liegt daher die Aufgabe zugrunde, ein Verfahren und eine Vorrichtung der eingangs genannten Art zu schaffen, mittels dem bzw. der Kurzschlüsse der erwähnten Art sicher vermieden werden können.

Diese Aufgabe wird verfahrensgemäß durch die kennzeichnenden Maßnahmen nach Anspruch 1 und vorrichtungsgemäß durch die kennzeichnenden Merkmale nach Anspruch 3 gelöst.

Durch die erfindungsgemäßen Maßnahmen wird die Ausbildung eines unterschiedliche Kontaktstellen überbrückenden Draht-tails sicher vermieden, wobei das Zurückziehen des Bond-Drahtes vorzugsweise im Bond-Takt erfolgt. Durch die Erfindung ist ein störungsfreies Kontaktieren d.h. Verbinden von wenigstens zwei Kontaktstellen eines Halbleiterbauelements oder dergleichen möglich, auch wenn die eine oder beide Kontaktstellen sich durch extrem kleine Kontaktflächen und minimalen Abstand voneinander auszeichnen. Auch kann durch die Erfindung in einfacher Weise die Bondlänge eingestellt bzw. in Grenzen variiert werden.

Bevorzugte konstruktive Weiterbildungen der Erfindung sind in den Unteransprüchen beschrieben bzw. beansprucht. Sie zeichnen sich durch geringen konstruktiven Aufwand und Funktionssicherheit aus.

Nachstehend wird eine vorteilhafte Ausführungsform der Erfindung anhand der beigefügten Zeichnung näher beschrieben.

Es zeigen:

Figur 1 einen Ultraschall-Bondkopf bzw. -Stempel mit Schneidwerkzeug und Draht-Rückzugeinrichtung im Schnitt, wobei der Bond-Stempel (wedge) sich in Drahtabtrenn-Stellung befindet; und

Figur 2 gebondete Kontaktstelle bzw. -Fläche in Draufsicht, wobei der gebondete Drahtabschnitt ohne und mit Draht-tail zum Vergleich dargestellt ist.

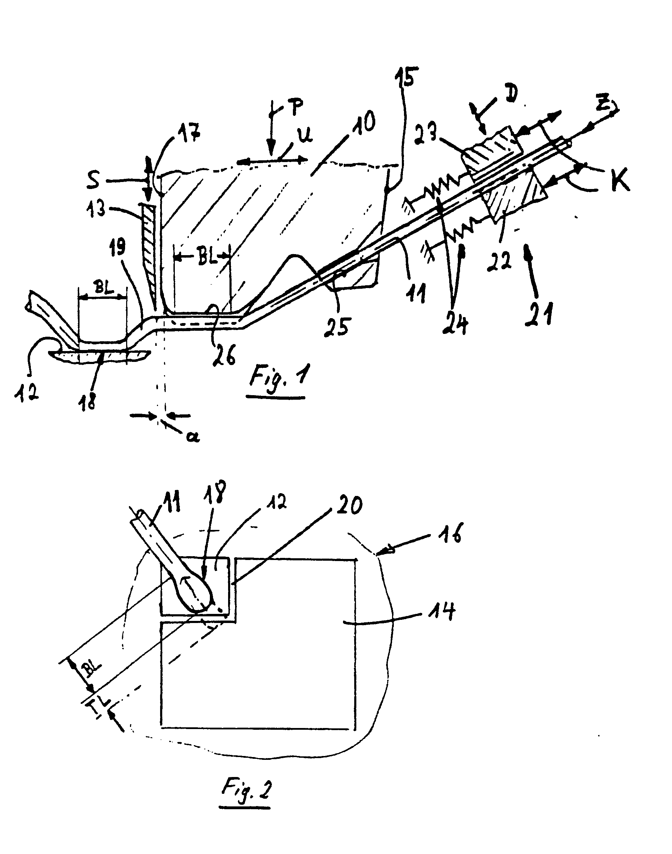

Mit dem in Figur 1 teilweise und im Schnitt dargestellten Bond-Stempel bzw. "wedge" 10 läßt sich ein elektrisch leitender, z. B. Aluminium-, Draht 11 an eine Kontaktstelle bzw. -Fläche 12 oder 14 (siehe Figur 2) anheften, konkret anschweißen, und zwar unter Einwirkung von Druck und Ultraschall. Zu diesem Zweck wird der "wedge" 10 mit vorbestimmtem, nämlich vom Drahtmaterial und vom Drahtdurchmesser abhängigen, Druck P beaufschlagt und ferner in Richtung des Doppelpfeils U Ultraschall-erregt. Die "Ultraschall-Anpressung" des Drahts 11 gegen die Kontaktstelle 12 bzw. 14 erfolgt nur kurzzeitig, d.h. im Millisekundenbereich. Das beschriebene Verfahren ist bekannt. Ebenso bekannt ist die Ausbildung des "wedge" 10 mit einem Draht-Schneidwerkzeug in Form eines in Richtung des Doppelpfeils S hin- und herbewegbaren Trennmessers 13, das an der der Drahtzuführungsseite 15 des "wedge" 10 gegenüberliegenden Seite 17 in geringem Abstand "a" von dieser angeordnet ist. Das Trennmesser 13 ist beim Ultraschall-Bonden mit etwas stärkeren Aluminium-Drähten erforderlich; etwas stärkere Bond-Drähte reißen bei der Wegbewegung des

"wedge" 10 von der Bond-Stelle 18 nicht selbsttätig ab, wie das z. B. beim Golddraht-Bonden der Fall ist. Das Trennmesser 13 wird in der Stellung gemäß Figur 1 wirksam, d.h. bei etwas von der Bondstelle 18 abgehobenem und in Richtung zur nächsten Bond- bzw. Kontaktstelle weiter bewegtem "wedge" 10. Durch diese "wedge"-Bewegung wird der an die Bond-Stelle 18 anschließende Drahtabschnitt 19 nach oben und von der Kontaktstelle bzw. -Fläche 12 weggebogen.

Das Trennmesser 13 muß vom "wedge" 10 zumindest geringfügig beabstandet (Abstand "a" in Fig. 1) sein, um die Ultraschall-Schwingung des "wedge" 10 in Richtung des Doppelpfeiles U nich störend zu beeinflussen. Dies bedeutet jedoch, daß der vom Trennmesser 13 abgetrennte Bonddraht 11 immer etwas über die Fläche 17 des "wedge" 10 hinausragt und einen sogenannten Drahttail bildet, der beim nächsten Anheften bzw. Bond-Vorgang aufgrund der Drahtverformung im Bondbereich noch stärker ausgeprägt wird. In Fig. 2 ist der beim herkömmlichen Bonden mit etwas stärkeren Aluminium-Drähten nicht zu vermeiden "tail" mit einer Länge TL in unterbrochener Linie dargestellt. Wie der Figur 2 dabei entnommen werden kann, kann bei kleineren Kontaktstellen bzw. -Flächen 12 dieser Draht-tail die benachbarte, gegenüber der ersten Kontaktfläche elektrisch isolierte (Isolierung 20) Kontaktstelle bzw. -Fläche 14 kontaktieren und zu einem elektrischen Kurzschluß führen, zumal dieser "tail" nicht durch den "wedge" 10 nach oben von der Kontaktfläche weggebogen wird wie der Drahtabschnitt 19 nach Figur 1.

Um diese Unzulänglichkeit bzw. Kurzschlußgefahr beim Bonden von insbesondere kleineren Kontaktstellen bzw. -Flächen zu vermeiden, wird erfindungsgemäß vorgeschlagen, dem "wedge" 10 eine Drahtrückzugseinrichtung zuzuordnen, die gemäß Figur 1 eine Drahtklemme 21 mit am Draht 11 angreifenden Klemmbacken 22, 23 umfaßt, von denen nur die obere Klemme 23 in Richtung des Doppelpfeiles D hin- und herbewegbar, d. h. in Zusammenwirkung mit der unteren Klemme 22 von einer Drahtklemmstellung in eine Drahtfreigabestellung (wie in Figur 1 gezeigt) und umgekehrt bringbar ist. Darüberhinaus ist die Drahtklemme 21 in Richtung des Doppelpfeiles K parallel zur Drahtzuführungsrichtung "Z" hin- und herbewegbar, wobei die Bewegung der Drahtklemme 21 in Richtung entgegen der Drahtzuführungsrichtung Z gegen die Wirkung eines elastischen Elements, hier einer Zugfeder 24 (in Figur 1 schematisch dargestellt), erfolgt. Mittels der Drahtklemme 21, die an der Drahtzuführungsseite des "wedge" 10 angeordnet ist und dessen Bewegungen folgt, kann der Draht 11 nach Abtrennung des gebondeten Drahtabscnitts durch das Trennmesser 13 in Richtung entgegen der Drahtzuführungsrichtung Z zurückgezogen werden, so daß der freie Drahtabschnitt mit der "wedge"-Seite 17 etwa bündig ist. Der Drahtrückzug muß selbst-Verständlich vor dem nächsten Anheften bzw. Bond-Vorgang erfolgen. Auf diese Weise wird die Ausbildung eines Draht-tails vermieden, wie in Figur 2 dargestellt ist, ferner läßt sich dadurch die Bondlänge BL in Grenzen variieren durch mehr oder weniger weiten Draht-Rückzug. Der Bond-Draht 11 erstreckt sich also mit seinem freien Endabschnitt über die Bond-Länge BL der Bond-Stelle 18 nicht hinaus.

Die Klemmbacke 23 wird zum Zwecke des Zurückziehens bzw. -Holens des Drahtes 11 in Klemmstellung gebracht und dann zusammen mit der unteren Klemme 22 gegen die Wirkung der Zugfeder 24 in Richtung entgegen der Drahtzuführungsrichtung Z um einen vorbestimmten Betrag, entsprechend der gewünschten Bondlänge BL bewegt. Die Rückholdistanz soll demnach vorzugsweise einstellbar sein. Als Antrieb für die Rückholbewegung der Drahtklemme 21 dient vorzugsweise ein Elektromagnet. Die Bewegung der Druckbacke 23 in Richtung des Doppelpfeiles D wird vorzugsweise durch eine Steuerschiene, -Scheibe oder -Hebel gesteuert. Auch dafür kann selbstverständlich ein elektromagnetischer Antrieb vorgesehen sein.

Der untere, den zu bondenden Bauteilen 16 zugewandte Teil des "wedge" 10 ist in an sich bekannter Weise ausgebildet und umfaßt eine schräg zur unteren Stirnfläche des "wedge" 10 bzw. schräg zu den Kontaktflächen 12 bzw. 14 gerichtete Bohrung 25, die als Führung für den zugeführten Bond-Draht 11 dient, sowie eine konkav gewölbte bzw. schalenförmige Pressfläche 26, mit der der Draht 11 gegen die Kontaktstelle bzw. -Fläche 12 bzw. 14 gedrückt und lokal durch die überlagerte Ultraschall-Schwingung in Richtung des Doppelpfeiles U im Bereich BL (wirksame Bondlänge) zum Zwecke der Verschweißung mit der Kontaktfläche geschmolzen wird.

Die Drahtklemme 21 und deren Antrieb ist vom "wedge" 10 vorzugsweise schwingungs-entkoppelt. Im übrigen muß die Drahtklemme 21 jedoch zusammen mit dem "wedge" 10 auf- und abbewegbar sein, um einen Drahtknick im Bereich der Drahtzuführungsseite 15 des "wedge" 10 zu vermeiden. Zu diesem Zwecke liegt auch die untere Klemmbacke 22 in Linie mit der Bohrung 25.

Sämtliche in den Unterlagen offenbarten Merkmale werden als erfindungswesentlich beansprucht, soweit sie einzeln oder in Kombination gegenüber dem Stand der Technik neu sind.

**Patentansprüche**

1. Verfahren zum Anheften (Bonden) eines dünnen, elektrisch leitenden Drahtes, insbesondere Aluminium-Drahtes, an elektrische Kontaktstellen bzw. -Flächen von elektrischen oder elektronischen Bauteilen, insbesondere Mikrochips oder Halbleiterbauelementen, bei dem der Draht kurzzeitig mittels eines ultraschallerregbaren Stempels (wedge) gegen die Kontaktstelle bzw. -Fläche gedrückt und anschließend in geringem Abstand von der der Drahtzuführungsseite des "wedge" gegenüberliegenden Seite abgetrennt wird, dadurch gekennzeichnet, daß der Draht nach Abtrennung und vor einem erneuten Bond-Vorgang wenigstens soweit zurückbewegt, vorzugsweise zurückgezogen, wird, daß sein freies Ende mit der der Drahtzuführungsseite des "wedge" gegenüberliegenden Seite etwa bündig ist.

2. Verfahren nach Anspruch 1, dadurch gekennzeichnet, daß der Draht mittels einer am "wedge", vorzugsweise an dessen Drahtzuführungsseite angeordneten Drahtklemme um eine vorbestimmte, vorzugsweise einstellbare, Distanz zurückgezogen wird.

3. Vorrichtung zum Anheften (Bonden) eines dünnen, elektrisch leitenden Drahtes, insbesondere Aluminium-Drahtes, an elektrische Kontaktstellen bzw. -Flächen von elektrischen oder elektronischen Bauteilen, insbesondere Mikrochips oder Halbleiter-Bauelementen, mit einem ultraschall-erregbaren Stempel (wedge) zum Anpressen des Drahts an die Kontaktstellen bzw. -Flächen und mit einem an der der Drahtzuführungsseite des "wedge" gegenüberliegenden Seite angeordneten und in geringem Abstand von dieser Seite wirksamen Schneidwerkzeug zum Abtrennen des Drahtes nach Durchführung eines Bond-Vorganges, insbesondere zur Durchführung des Verfahrens nach Anspruch 1 oder 2, dadurch gekennzeichnet, daß eine Einrichtung vorgesehen ist, mittels der der Draht (11) nach Abtrennen und vor einem erneuten Bond-Vorgang wenigstens soweit zurückbewegbar ist, daß sein freies Ende mit der der Drahtzuführungsseite (15) des "wedge" (10) gegenüberliegenden Seite (17) etwa bündig ist.

4. Vorrichtung nach Anspruch 3, dadurch gekennzeichnet, daß die Einrichtung zum Zurückbewegen des Drahtes (11) eine am "wedge" (10), vorzugsweise an dessen Drahtzuführungsseite (15), angeordnete und relativ zum "wedge" (10) in Richtung etwa parallel zur Drahtzuführungsrichtung (Z) hin- und herbewegbare Drahtklemme (21) umfaßt, derart, daß sie sich bei Bewegung in Drahtzuführungsrichtung (Z) in einer Außer-Klemm- bzw. Drahtfreigabe-Stellung befindet und umgekehrt.

5. Vorrichtung nach Anspruch 4, dadurch gekennzeichnet, daß die Klemmstrecke der Drahtklemme (21) einstellbar ist.

6. Vorrichtung nach Anspruch 4 oder 5, dadurch gekennzeichnet, daß die Klemmbacke bzw. -Backen (22, 23) der Drahtklemme (21) durch einen elektromagnetiechen Antrieb, eine Steuerschiene, -Scheibe oder dergleichen betätigbar sind.

7. Vorrichtung nach einem der Ansprüche 4 bis 6, dadurch gekennzeichnet, daß die Drahtklemme (21) gegen die Wirkung eines elastischen Elements, vorzugsweise Feder (24), in Richtung entgegen der Drahtzuführungsrichtung (Z) bewegbar ist, vorzugsweise mittels eines elektromagnetischen Antriebs.

**Claims**

1. A process for bonding a thin, electrically conductive wire, in particular aluminium wire, onto electrical contact points or surfaces of electrical or electronic components, in particular microchips or semiconductor components, in which the wire is pressed momentarily against the contact point or surface by means of an ultrasonically excitable wedge and is then severed at a short distance from the side remote from the wire supply side of the edge, characterised in that the wire is moved back, preferably pulled back, after being severed and before a renewed bonding operation at least sufficiently far for its free end to be roughly flush with the side remote from the wire supply side of the wedge.

2. A process according to claim 1, characterised in that the wire is pulled back by a predetermined, preferably adjustable distance by means of a wire clamp arranged on the wedge, preferably on the wire supply side thereof.

3. A device for bonding a thin, electrically conductive wire, in particular aluminium wire, onto electrical contact points or surfaces of electrical or electronic components, in particular microchips or semiconductor components, with an ultrasonically excitable wedge for pressing the wire onto the contact points or surfaces and with a cutting tool which is arranged on the side remote from the wire supply side of the wedge and acts at a short distance from this side for severing the wire after a bonding operation has been carried out, in particular for carrying out the process according to claim 1 or 2, characterised in that an arrangement is provided by means of which the wire (11) can be pulled back after being severed and before a renewed bonding operation at least sufficiently far for its free end to be roughly flush with the side (17) remote from the wire supply side (15) of the wedge (10).

4. A device according to claim 3, characterised in that the arrangement for pulling back the wire (11) comprises a wire clamp (21) which is arranged on the wedge (10), preferably on the wire supply side (15) thereof and can be moved to and fro relative to the wedge (10) in a direction roughly parallel to the wire supply direction (Z) in such a way that it is located in an unclamping or wire release position when moved in the wire supply direction (Z) and vice versa.

5. A device according to claim 4, characterised in that the clamping region of the wire clamp (21) is adjustable.

6. A device according to claim 4 or 5, characterised in that the clamping jaw or jaws (22, 23) of the wire clamp (21) can be actuated by an electromagnetic driving means, a control rail, disc or the like.

7. A device according to one of claims 4 to 6, characterised in that the wire clamp (21) can be moved against the action of an elastic element, preferably a spring (24) in a direction opposed to the wire supply direction (Z), preferably by means of an electromagnetic driving means.

## Revendications

1. Procédé de fixation (bonding) d'un mince fil électriquement conducteur, en particulier d'un fil d'aluminium, sur des points et respectivement des surfaces de contact électrique de composants électriques ou électroniques, en particulier des microplaquettes ou des composants à semiconducteurs au cours duquel le fil est appliqué temporairement, au moyen d'un poinçon (wedge) excitable par ultrasons, contre le point et respectivement la surface de contact, puis sectionné à faible distance du côté opposé au côté d'amenée de fil du "wedge", caractérisé en ce que, après le sectionnement et avant une nouvelle opération de bonding, le fil est ramené, de préférence tiré, en arrière au moins jusqu'à ce que son extrémité libre affleure à peu près le côté opposé au côté d'amenée de fil du "wedge".

2. Procédé selon la revendication 1, caractérisé en ce que le fil est tiré en arrière d'une distance prédéterminée, de préférence réglable, au moyen d'un serre-fil disposé sur le "wedge", de préférence sur le côté d'amenée de fil de celui-ci.

3. Dispositif de fixation (bonding) d'un mince fil électriquement conducteur, en particulier d'un fil d'aluminium, sur des points et respectivement des surfaces de contact électrique de composants électriques ou électroniques, en particulier de microplaquettes ou de composants à semiconducteurs, comprenant un poinçon (wedge) excitable par ultrasons pour l'application du fil contre les points et respectivement les surfaces de contact et un outil de coupe pour le sectionnement du fil après l'exécution d'une opération de bonding, disposé du côté opposé au côté d'amenée de fil du "wedge" et agissant à faible distance dudit côté, en particulier pour la mise en oeuvre du procédé selon l'une des revendications 1 ou 2, caractérisé en ce qu'il est prévu un dispositif permettant, après le sectionnement et avant une nouvelle opération de bonding, de ramener le fil (11) en arrière, à savoir au moins de telle façon que son extrémité libre affleure à peu près le côté (17) opposé au côté d'amenée de fil (15) de "wedge" (10).

4. Dispositif selon la revendication 3, caractérisé en ce que le dispositif pour le déplacement en arrière du fil (11) comprend un serre-fil (21) monté sur le "wedge" (10), de préférence sur le côté d'amenée de fil (15) de celui-ci et pouvant être animé d'un mouvement de va-et-vient par rapport au "wedge" (10), à peu près parallèlement à la direction d'amenée du fil (Z) de telle façon que, lors du mouvement dans la direction d'amenée du fil (Z), ledit serre-fil se trouve dans une position de non-serrage et respectivement de libération du fil et inversement.

5. Dispositif selon la revendication 4, caractérisé en ce que la distance de serrage du serre-fil (21) est réglable.

6. Dispositif selon l'une des revendication 4 ou 5, caractérisé en ce que la ou les mâchoires de serrage (22, 23) du serre-fil (21) peuvent être actionnées par une commande électromagnétique, un rail de commande, un disque de commande ou analouge.

7. Dispositif selon l'une des revendications 4 à 6, caractérisé en ce que le serre-fil (21) peut être déplacé contre l'action d'un élément élastique, de préférence un ressort (24), dans la direction opposée à la direction d'amenée du fil (Z), de préférence au moyen d'une commande électromagnétique.

_Fig. 1_

_Fig. 2_